# EUROPEAN PATENT APPLICATION

(11) **EP 1 455 208 A1**
(43) Date of publication of application: **08.09.2004**
(21) Application number: 03251328.5
(22) Date of filing: 05.03.2003
(51) Int. Cl.: G02B 6/42

(54) **Electrical connection arrangement, component and method, for instance for high speed optical transceivers**

(71) Applicant: Agilent Technologies, Inc. - a Delaware corporation -, Palo Alto, CA 94303-0870 (US)
(72) Inventor: Sabbatino, Salvatore, Agilent Technologies Italia, 10148 Torino (IT); Bendelli, Giampaolo, Agilent Technologies Italia, 10148 Torino (IT)
(74) Representative: Coker, David Graeme

(57) **Abstract**

A connection arrangement for connecting an optical sub assembly (OSA) and an electrical sub assembly (ESA) in optoelectrical apparatus. The arrangement includes a flexible circuit (1) interposed as a connector element between the optical sub assembly (OSA;5) and the electrical sub assembly (ESA), the flexible circuit (1) including a flexible substrate (1a) carrying electrically conductive formations (1b). The flexible circuit (1) at least partly extends into one of the optical (OSA) and electrical (ESA) sub assemblies to form a substrate for supporting components (3,4) thereof.

## Description

Transmission speed is an ever-increasing parameter in data communication systems. Achieving and ensuring the required performance levels by resorting to conventional methods of interconnection becomes increasingly difficult in such systems as transmission speed increases. This is particularly true for optical communication transceivers for use in systems where large volumes of data are aggregated to form serial data streams with very high rates and these data streams are subsequently used to drive light sources such as laser sources.

Under these operating conditions, wiring in the conventional sense no longer offers reliable interconnection with fully satisfactory electrical performance, at least insofar as arrangements reasonably adapted to be manufactured at the industrial level are considered.

Additionally, in some optical communications transceivers, the lengths of the optical components in the transceiver may be varied in order to provide optical alignment. This results in a varying distance between the optical components and the electrical components of the transceiver, which is a source of additional difficulty in achieving and ensuring optical operation.

In the field of optical communications, flexible connectors (or in generally, flexible connection arrangements) are used to join the so-called optical sub assembly (OSA) to the electrical sub assembly (ESA). In these prior art arrangement interconnection of the electrical circuits to the inner portions of the OSA is by means of complex feed-through arrangements. Other OSA-ESA interconnection arrangements resort to coaxial structures. These however tend to be expensive, difficult to miniaturise and may end up by being hardly flexible.

Still other existing interconnection methods of electrical assemblies to optical assemblies use brazed copper leads. However, such leads achieve adequate electrical performance only if the distance between the electrical and the optical assemblies can be exactly controlled.

The need is therefore felt for improved solutions that, while sharing the advantages of the prior art arrangements considered in the foregoing, do not exhibit the inherent drawbacks thereof.

The object of the invention is to provide a response to such a need. According to the present invention, that object is achieved by means of a connection arrangement having the features set forth in the claims that follow. The invention also includes a component for such a connection arrangement as well as a corresponding method of connection.

A presently preferred embodiment of the invention is thus a connection arrangement for connecting an optical sub assembly (OSA) and an electrical sub assembly (ESA) in optoelectrical apparatus. The arrangement includes a flexible circuit interposed as a connector element between the optical sub assembly and the electrical sub assembly (ESA). The flexible circuit includes a flexible substrate carrying electrically conductive formations. The flexible circuit extends at least partly (e.g. via the flexible substrate) into one of the optical and electrical sub assemblies to form a substrate for supporting components thereof. A preferred embodiment of the invention also covers a component for such an arrangement, the component including the flexible circuit having said flexible substrate and at least one component of an optical sub assembly and/or an electrical sub assembly mounted on the flexible circuit.

In brief, the arrangement of the invention is adapted to provide electrical connection with good parametric performance up to 10GHz and beyond. In the presently preferred embodiment, the invention also offers a means to accommodate variations in the length of optical assemblies and the distance between optical and electrical assemblies connected thereby.

The presently preferred embodiment of the invention offers the opportunity of using a flexible member of the connector as an electrical substrate in the optical sub assembly or OSA. This results in the cost of the OSA package being correspondingly reduced especially in comparison with conventional ceramic substrates, while the step of attaching the OSA to a separate flexible member is dispensed with. Any complex RF feed-through arrangement is avoided, thus giving a rise to a solution that is compatible with standard chip mounting technology such as flip-chip and bonding technologies. Additionally, the arrangement disclosed herein provides good thermal dissipation of the package, which is preferably obtained by means of a metallic stiffener provided at the bottom side of the arrangement.

The invention will now be briefly described, by way of example only, by referring to the enclosed figures of drawing, wherein:
- figure 1 is a general perspective view of a connector arrangement associated with a so-called optical sub assembly (OSA),
- figure 2 is another general perspective view of the connector arrangement of figure 1, where some of the components associated therewith were removed,
- figure 3 is a sectional view along line III-III of figure 1, and
- figure 4 shows the possible use of the connector arrangement of figures 1 and 2 to connect an optical sub assembly (OSA) to an electrical sub assembly (ESA) in an optical communication transceiver.

In the annexed figures of drawing, reference 1 designates as a whole a flexible circuit of the kind currently referred to briefly as "flex". Such flexible circuits are known in the art and are essentially comprised of a ribbon-like flexible substrate 1a of an electrically insulating material over which circuit elements in the form of e.g. metalized lines 1b are provided.

A suitable electrically insulating material for forming the flexible substrate 1a is the polyimide material currently available from Du Pont under the trade name Kapton.

Technologies for providing metalizations 1b over the substrate 1a are similarly well known in the art and include i.e. vapour deposition, metalization followed by physical and/or chemical etching and the like.

Specifically, the metalizations 1b can be provided in the form of controlled impedance transmission lines permitting the transmission of high-speed signals (for instance in the range of 10GHz or 10Gbits/s.).

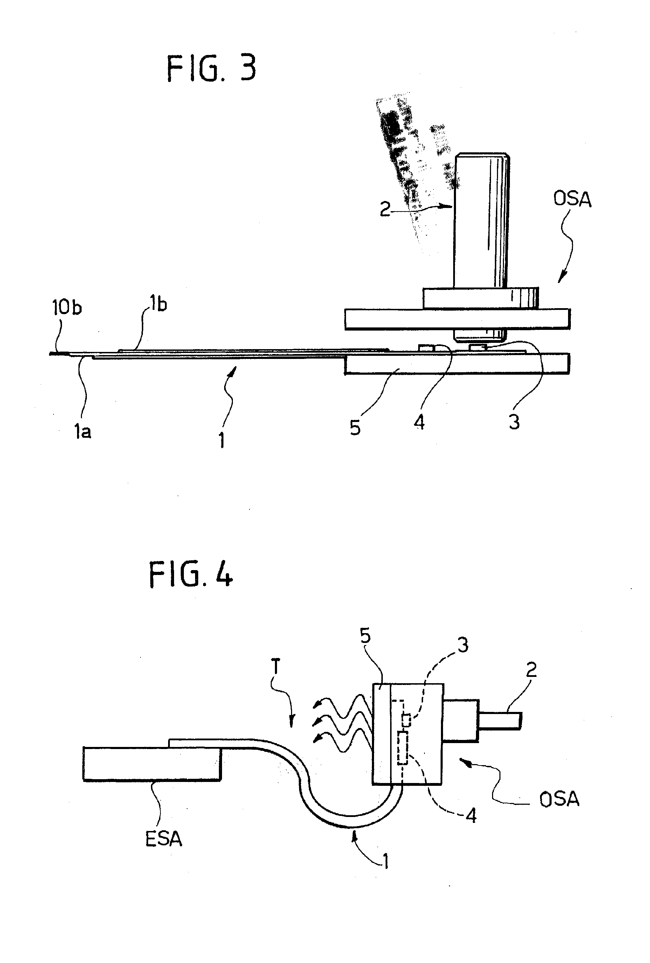

These transmission lines can be easily provided in the form of metallic strips having respective ends 10b protruding at one end of the flexible circuit 1 to provide cantilevered leads adapted for use in connecting the flexible circuit 1 with an electrical sub assembly (ESA), this being shown as such only in figure 4 of the drawing.

The mechanical attachment of the flexible circuit 1 to the ESA may be achieved in various ways.

Conventional soldering or solder balls can be used. Alternatively, glue may be used to mechanically connect the flexible circuit 1 to the ESA in combination with other techniques such as wire bonding to provide the electrical connections between the leads 10b and the electrical connection in the ESA.

A particularly preferred embodiment provides for such a connection being achieved by means of ultrasonic or thermo-sonic compression bonding between the conductors 1b of the flexible circuit and the conductors in the ESA.

Still another solution is to use an anisotropic conductive film to guarantee the electrical continuity and glue to achieve mechanically connection. The transmission lines 1b maintain their nature of controlled impedance lines when the flexible circuit 1 is deformed during the manufacturing and/or assembly process.

The end of the flexible circuit 1 opposed to the ESA is not just connected but also at least partly integrated to an optical sub assembly or OSA.

The OSA is generally provided for connection to an optical fibre (not shown) via a ferrule 2 and has associated opto-electrical or electro-optical converters such as a photo detector 3 possibly having associated an amplifier 4.

In a manner known per se, light coming from the fibre coupled to the ferrule 2 impinges upon the photo detector 3. Opto-electrical conversion in the photo detector 3 gives rise to an electrical current that (possibly amplified by passing through the amplifier 4) is sent on one or more lines 1b of the flexible circuit 1 to be transmitted to the ESA for processing at the electrical level.

Other lines included in the flexible circuit 1 are used for transmitting signalling signals between the ESA and the OSA in a manner known per se.

At least partial integration of the flexible circuit 1 to the OSA is preferably achieved by means of a stiffener member 5. This is usually comprised of a material such as alumina or copper.

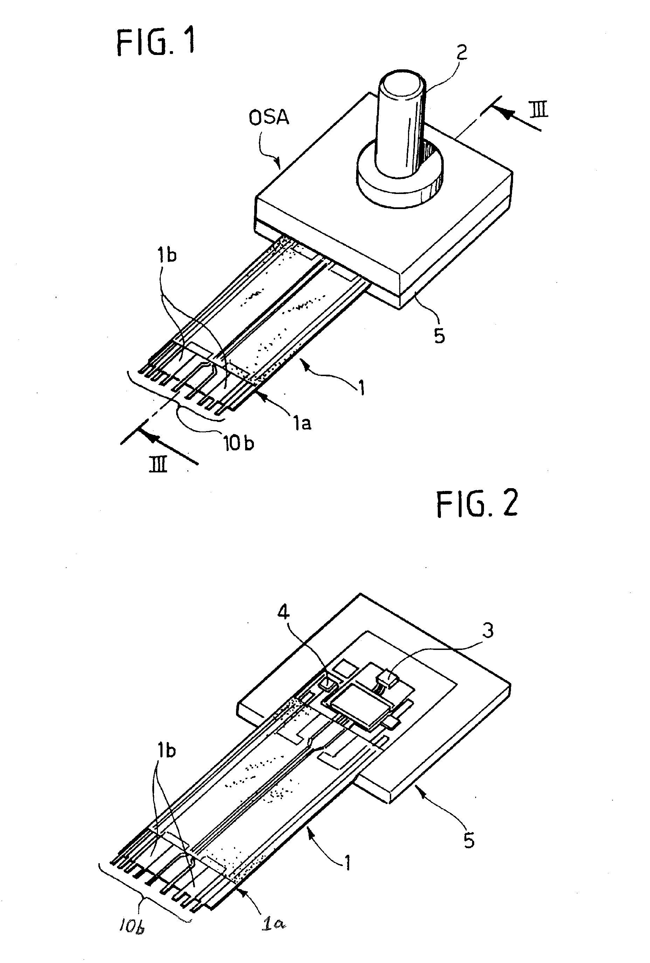

As better appreciated in the views of figures 2 and 3, the flexible circuit 1 is intended to extend in a sort of sandwich arrangement between the body of the OSA and the stiffener member 5.

The flexible circuit 1 is thus adapted to act as a substrate within the OSA to support the photo detector 3 and the amplifier 4 - if present.

Stated otherwise, in the arrangement shown, the flexible circuit 1 (and, more to the point, the flexible substrate 1a) does not merely extend - to - the OSA but rather - into - the OSA.

In that way, the end portion of the substrate 1a extending into the OSA does in fact become a part of the OSA itself adapted to support parts of the OSA such as the photo detector 3 and the amplifier 4.

The same techniques referred to in the foregoing for connecting the flexible circuit 1 to the OSA can be - at least in principle - used for connecting the flexible circuit 1 to the ESA.

Mechanically attachment of the flexible circuit 1 to the stiffener member 5 comprising the back of the OSA package is preferably via gluing.

The arrangement shown herein ensures good high frequency signal transmission that leads to better RF performance. Additionally, the arrangement disclosed herein allows for wide mechanical tolerances in terms of possible variations of the mutual distance and, in general, the mutual positioning of the OSA and the ESA. The arrangement disclosed herein exhibits the additional possibility of allowing the OSA to be rotated with respect to the ESA.

These results can be achieved by means of simple, extensively experimented joining techniques while providing good thermal dissipation as schematically shown at T in figure 3. To that end, the "back" of the stiffener member 5 apposed to the OSA is preferably provided with some sort of a ribbed or finned arrangement to increase dissipation properties.

The arrangement described and shown herein provides for the OSA to be essentially an opto-electrical converter that receives an optical signal from the fibre coupled to the ferrule 2 and converts it into an electric signal fed to the ESA via the lines 1b in the flexible circuit 1.

The same arrangement is obviously adapted for use in connection with an OSA including an electro-optical converter such as a laser source fed with electrical signals provided via the flexible circuit 1 to generate an optical signal that is injected into the optical fibre coupled with the ferrule 2. In that case, the arrangement in question permits the driver for the laser source to be arranged very close to the laser source itself. This is particularly advantageous for those arrangements intended to operate in the 10GHz range and over.

The arrangement described also lends itself to be realized starting from a pre-assembled component including the flexible circuit 1 having said flexible substrate 1a and at least one component of the optical sub assembly and/or the electrical sub assembly (e.g. the photodetector 3 and/or the amplifier 4) already mounted on the flexible circuit 1, possibly already properly connected with the lines 1b.

Of course, without prejudice to the underlying principle of the invention, the details and embodiments may vary, also significantly, with respect to what has been shown and described, just by way of example, without departing from the scope of the invention as defined by the annexed claims. For instance, possible variant of the invention may include the use of a second stiffener member.

## Claims

1. A connection arrangement for connecting an optical sub assembly (OSA) and an electrical sub assembly (ESA) in optoelectrical apparatus, the arrangement including a flexible circuit (1) interposed as a connector element between said optical sub assembly (OSA) and said electrical sub assembly (ESA), said flexible circuit (1) including a flexible substrate (1a) carrying electrically conductive formations (1b), and wherein said flexible circuit (1) at least partly (1a) extends into at least one of said optical (OSA) and electrical (ESA) sub assemblies to form a substrate for supporting at least one component (3, 4) of at least one of said optical (OSA) and electrical (ESA) sub assemblies.

2. The arrangement of claim 2, **characterized in that** said electrically conductive formations are in the form of metalizations (1b).

3. The arrangement of either of claims 1 or 2, **characterized in that** said electrically conductive formations are in the form of controlled impedance transmission lines (1b).

4. The arrangement of any of the previous claims, **characterized in that** said flexible substrate (1a) is a polyimide film.

5. The arrangement of any of the previous claims, **characterized in that** said flexible circuit (1) is in the form of a ribbon element.

6. The arrangement of any of the previous claims, **characterized in that** said flexible circuit (1) is connected with at least one of said optical (OSA) or said electrical sub assemblies (ESA) by means of a technique selected from the group consisting of soldering, gluing, wire-bonding, ultrasonic compression, thermal-sonic compression, using an anisotropic conductive film, and combinations thereof

7. The arrangement of any of the previous claims, **characterized in that** includes a stiffener member (5) adapted for sandwich-like connection of said flexible circuit (1) between at least one of said optical (OSA) and electrical (ESA) sub assemblies and said stiffener member (5).

8. The arrangement of claim 7, **characterized in that** said stiffener member (5) is in the form of a plate.

9. The arrangement of either of claims 7 or 8, **characterized in that** said stiffener member (5) is arranged for thermal dissipation (T)

10. A component for an arrangement according to any of claims 1 to 9, **characterized in that** it includes:
- said flexible circuit (1) having said flexible substrate (1a), and
- at least one component (3, 4) of at least one of said optical (OSA) and electrical (ESA) sub assemblies mounted on said flexible circuit (1).

11. The component of claim 10, **characterized in that** said flexible circuit (1) includes a flexible substrate (1a) carrying electrically conductive formations (1b) and **in that** said at least one component (3, 4) is connected with said conductive formations (1b).

12. A method of connecting an optical sub assembly (OSA) and an electrical sub assembly (ESA) in optoelectrical apparatus, including the steps of:
- interposing a connector element between said optical sub assembly (OSA) and said electrical sub assembly (ESA),
- providing said flexible circuit (1) with a flexible substrate (1a) adapted for carrying electrically conductive formations (1b), and
- letting said flexible circuit (1) at least partly (1a) extend into at least one of said optical (OSA) and electrical (ESA) sub assemblies to form a substrate for supporting at least one component (3, 4) of at least one of said optical (OSA) and electrical (ESA) sub assemblies.

13. The method of claim 12, **characterized in that** it includes the steps of:
- providing at least one stiffener member (5) adapted for sandwich-like connection of said flexible circuit (1) between at least one of said optical (OSA) and electrical (ESA) sub assemblies and said stiffener member (5), and
- connecting said flexible circuit (1) to said stiffener member (5) and
- connecting said stiffener member (5) to said optical sub assembly (OSA).
